Europäisches Patentamt

European Patent Office

Office européen des brevets

(11) Publication number: **0 318 549 B1**

# EUROPEAN PATENT SPECIFICATION

(45) Date of publication of patent specification: **31.03.93**   (51) Int. Cl.⁵: **G01R  31/28**, G01R 19/00, G01R 17/06, G01R 1/067

(21) Application number: **88905120.7**

(22) Date of filing: **18.05.88**

(86) International application number: **PCT/US88/01648**

(87) International publication number: **WO 88/09489 (01.12.88 88/26)**

(54) **TEST METERS.**

(30) Priority: **22.05.87 US 53385**

(43) Date of publication of application: **07.06.89 Bulletin  89/23**

(45) Publication of the grant of the patent: **31.03.93 Bulletin  93/13**

(84) Designated Contracting States: **DE GB IT**

(56) References cited:
US-A- 3 834 238     US-A- 4 298 837
US-A- 4 532 470     US-A- 4 563 770
US-A- 4 571 689     US-A- 4 633 221
US-A- 4 634 971     US-A- 4 672 306

(73) Proprietor: **OMEGA ENGINEERING, INC.
One Omega Drive
Stamford, CT 06907-0047(US)**

(72) Inventor: **HOLLANDER, Milton, Bernard
One Arbor Road
Stamford, CT 06903(US)**
Inventor: **McKINLEY, William, Earl
77 Knox Road
Stamford, CT 06907(US)**
Inventor: **CRIMMINS, James, Patrick
14 Post Road East
Westpost, CT 06880(US)**
Inventor: **STORER, Ian, K.
20 Sherwood Drive
Westport, CT 06880(US)**

(74) Representative: **Pedder, James Cuthbert et al
Barlin Associates, 50 Throwley Way
Sutton, Surrey SM1 4BW. (GB)**

Rank Xerox (UK) Business Services
(3. 10/3.5x/3.0. 1)

## Description

### Field Of The Invention

This application is a Continuation in Part of U.S. Serial No. 07/053,385 filed May 22, 1987 by MILTON BERNARD HOLLANDER and WILLIAM EARL McKINLEY entitled TEST METERS.

The present invention relates to test meters, particularly of the type employed for testing an electrical circuit or component for one or a plurality of parameters, e.g., multimeters; and provides improvements in meters of this type which greatly enhance their convenience and their efficiency of use.

Multimeters are well known in electronics, research, and trouble-shooting contexts for testing, typically voltage, current and resistance with a single instrument. Often, meters of this type will further have temperature-sensing capability. These meters almost universally have a visual display for reporting test results and one or more switches on the meter for selecting the test parameter and scale range desired. Hand-held probes are typically employed for contacting a work piece at suitable test points.

Unfortunately, where it is necessary to run a variety of tests, it is often inconvenient to set the probes down, change switch positions, and again place the probes in contact with the desired test points.

It is also inconvenient at times for the operator to change his direction of view from the test points to the visual display. While meters with voice reporting are know, the reporting format will in many circumstances detract from its apparent appeal.

It would be advantageous to have a test meter which would overcome at least one of the noted disadvantages by enabling switching between a plurality of test or report formats without moving test probes from test points and/or enabling variations in the format of an audible report.

### Background Art

In U.S. Patent 4,563,770, Lemelson and Grund disclose an electrical measuring instrument, such as a multimeter, which enables the results of a measurement to be displayed visually as well as by synthesized speech. The meter includes an electrical circuit for the analyzing signals generated in making measurements to assure that no speech report is produced until the signals have stabilized. A foot-operated, normally-open switch permits the operator to trigger the operation of the speech synthesizer when it is desired to generate audible synthetic speech, and also provides the operator with a means for repeating the most recent measurement in the event the operator did not properly hear the previous speech indication of the measurement. While an object of the invention is to enable blind persons to more easily employ the meter due to its speech report, the meter does not solve some of the more troublesome problems with meters with conventional visual displays, much less with speech reporting systems.

Regardless of the means employed for reporting, be it visual or audible, test meters have the nearly universal problem that the operator's hands and vision must usually give attention to the area of the test points. Often it is desired to switch among a plurality of test or report formats; however, there is no provision for such by the device of Lemelson and Grund. For example, where the operator has both hands busy on a complex electrical workpiece and wishes to test resistance followed by voltage and then current, he must remove his test probes from the locale of the test points, manually reset the meter, and again find the test points.

In U.S. Patent 4,604,569, Tedd and Kennedy describe a multimeter having two slide switches on the meter to control test format and an audible alarm to warn of incompatible settings to control test format. Each of the switches is set by the operator to control a different measurement function. Where the operator makes a selection of two incompatible setting, a buzzer sounds. While this feature is advantageous, it requires manual setting of the switches and permits the incompatible settings to be made. It would be more desirable to have a meter which could be set from a remote location, e.g., at the location where the operator is using his hands to perform the test of the circuitry, and preferably to include circuitry which would not permit the incompatible test format to be selected and would audibly advise the operator of such by spoken word.

In U.S. Patent 4,633,221, Bradshaw and Evans describe a multimeter including a dual slope analog-to-digital converter having automatic short cycle range determination. The converter adjusts the time period of the signal integrate phase to accommodate different ranges of input signals. Range selection is achieved automatically and rapidly without the need for displaying an out of range reading. While this appears to enhance the utility of typical autoranging meters, it would be desirable to have a meter which, preferably would permit selecting a desired test formal without the operator removing his hands or attention from his workpiece. It would be further desirable to have a meter of this type which would let the operator know in plain English or other language of choice, which test format, in terms of parameters and scale had been selected.

Enabling a meter to report results as synthesized speech is not a full answer to the problems with convenience and efficiency of use. Simply verbalizing reports adds a drawback that, in many cases, much of the information is repetitive and need not be reported. For example, where a long series of tests of one parameter is called for, it is not necessary to report that parameter in all instances and to report all decimal points placements. Often a format, which enabled once reporting the parameter being tested followed by a series of significant digit reports for each test point would not only be adequate, but be desired. And, under the circumstances of the present invention, where remote selection of test format, is available, it would be advantageous to enable an audible report of the test format selected.

## Disclosure Of The Invention

The present invention seeks to provide a test meter having means for selecting, from a position remote from the meter, between a plurality of test and/or report formats, the test meter having at least one test probe which includes means for selecting among a plurality of test and/or report formats.

According to the invention, there is provided a test meter arranged for testing a plurality of measurable parameters, including indicating means for giving a user a respective indication of each of said parameters, an independently locatable and movable probe for sensing a parameter and providing a test signal to the meter indicative of that parameter, control means by which the user is able to cause the meter to give said respective indications, and selector means responsive to electrical signals caused to be generated by the user on an electrical lead, for changing the format of a report produced by the test meter through a plurality of different formats in a predetermined sequence and for changing the formats of test parameters used by the test meter through a plurality of different formats in a predetermined sequence, in which the probe has an extended multi-conductor lead detachably connected to the test meter; one of the conductors in the multi-conductor lead being coupled to a first switch means of the selector means and another one of the conductors in the multi-conductor lead being coupled to a second switch means the selector means; the probe having a first control switch coupled to send an electrical signal on the said one conductor in the lead so as to operate the first switch means to change the report format of the test meter; and the probe having a second control switch coupled to send an electrical signal on the said other conductor in the lead so as to operate the second switch means to change the test parameter format of the test meter. Desirably, the meter will include a visual display for reporting test results, and means for audible reporting test information comprising: means for storing a plurality of selectable report formats; a speech synthesizer; a microprocessor programmed to direct a selected report format to be utilized by the speech synthesizer; and an amplifier and speaker to report test information as speech in the selected report format.

According to a particular embodiment, the invention provides a test meter capable of reporting test results as speech in any one of a plurality of selectable report formats, which comprises: means for receiving a test signal, and generating a meter output indicative of a measured value of a parameter, and directing said meter output to a microprocessor; means for storing a plurality of selectable report formats and directing a selected one to said microprocessor; selector means for causing a particular report format to be directed to said microprocessor; a speech synthesizer; and a microprocessor programmed to receive said meter output and cause the speech synthesizer to audible report test results in a selected format. As in the other embodiment, preferably the test meter will also include a visual display for reporting test results, and the selector means will be operable responsive to a remote stimulus. Preferably, the means for receiving test signals comprises a contact probe configured for being held and positioned by hand and includes an electrical switch which is operable by hand while said probe is held in contact with a desired test point. Most preferably, two switches will be located on the probe and operable by hand, one switch being dedicated to control test format and the other being dedicated to control report format.

According to one preferred embodiment of the invention, the two principal aspects are combined to provide a multimeter which provides even further improved efficiencies and use of operation due to the enhanced ability of the operator to interact with the meter with a minimum of required distractions. The multimeter according to this aspect of the invention comprises: selector means including a microprocessor, operably responsive to a remote stimulus as well as switching means on the meter, for causing the meter to operate in desired test and report formats; probe means for receiving a test signal; an autoranging multimeter circuit capable of generating a meter output responsive to said test signal and indicative of a measured value of a parameter, and directing said meter output to a microprocessor; means for storing a plurality of selectable report formats and directing a selected one to said microprocessor; selector means for causing a particular report format to be directed to said microprocessor; a speech synthesizer; and a microprocessor programmed to receive said meter output and cause the speech synthesizer to audible report test results in a selected format.

According to still another embodiment in accordance with the invention a speaking multimeter is provided in which a main microprocessor controls its operation including automatic ranging, responding to probe inputs and servicing a display. A replaceable speech module is employed having a speech chip and a second microprocessor connected between the main processor and the speech chip. The main processor delivers meter data to the second microprocessor This responds by sending command signals to the speech chip to cause it to speak the displayed meter data according to language rules programmed in the second processor. In this manner, the meter design can remain the same no matter where in the world it may be used while the speech module is altered to speak the local language.

Brief Description Of Drawings

The invention will be better understood and its advantages will be more apparent from the following detailed description of Best Modes Of The Invention, especially when read in light of accompanying drawings, wherein:

Figure 1 is a perspective view showing the outward appearance of a multimeter according to the present invention;

Figure 2 shows the detail of a female connector on the front panel of the multimeter for a specialized contact probe of the present invention;

Figure 3 shows, in perspective, the detail of a male connector for mating a specialized contact probe of the invention with a meter by means of a female connector as shown in Figure 2;

Figure 4 is a perspective view of a preferred embodiment of the invention showing a speaker at the rear of a multimeter;

Figure 5 shows, schematically and partially in section, a foreshortened view of a specialized contact probe of the invention; and

Figure 6 is a block diagram showing the arrangement of circuit components for a preferred embodiment of the invention.

Figure 7 is a perspective view of another "speaking" test meter in accordance with the invention;

Figure 8 is a rear end view of the meter of Figure 7;

Figure 9 is a right side view in elevation of the meter of Figure 7;

Figure 10 is a left side view in elevation of the meter of Figure 7;

Figure 11 is a block diagram view of the electrical circuitry used in the test meter of Figure 7;

Figure 12 is a flow chart of the operation of the main processor in the test meter of Figure 7;

Figure 13 is a general flow chart of the operation of one speech module used in a test meter of this invention;

Figure 14 is a more detailed view for a flow chart for the speech module used in a test meter of this invention;

Figure 15 is a listing of all data transferred from a main processor to a speech module used in the test meter of this invention;

Figure 16 is a listing of words stored in digital format within a speech chip used in the test meter of this invention;

Figure 17 is a more detailed flow chart of steps used in operating a speech module used in a test meter of the invention; and

Figures 18-21 are flow charts used to speak measurements using respectively different radix routines.

Best Mode Of The Invention

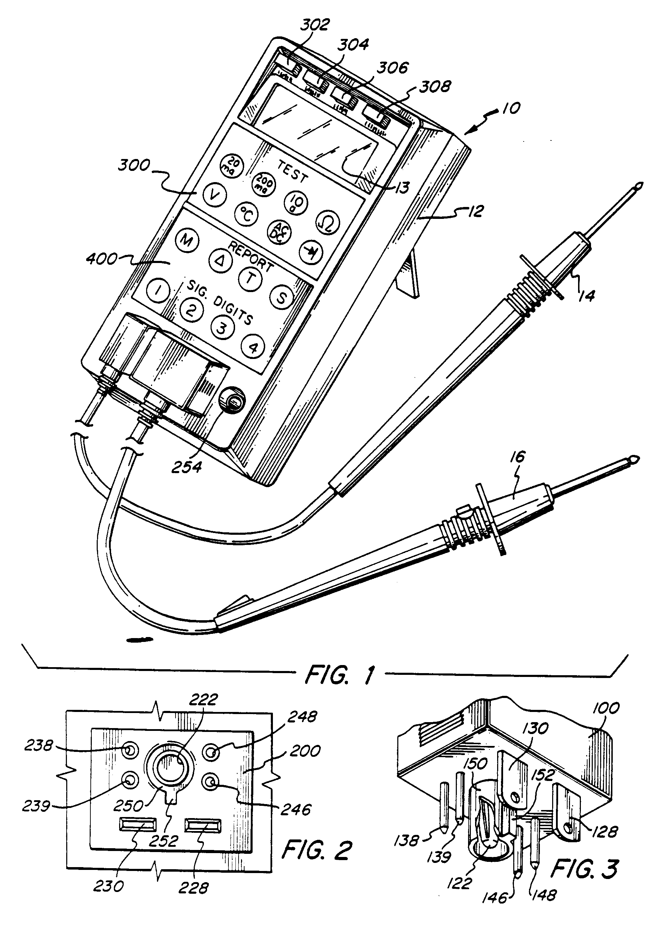

The improvements provided by the invention can be employed in meters for testing one or a plurality of physical parameters. The meters can employ one or a plurality of contact probes or other sensors. The practical significance of the advantages are, however, most easily appreciated in test meters having a plurality test or report formats which employ at least two contact probes. Accordingly, for ease in describing the invention, the various improvements will be explained in the context of an electronic multimeter capable of testing voltage, current and resistance. The meter shown in Figure 1 is a hand-held meter of this type, and additionally has the capability of measuring temperature.

The meter 10 shown in Figure 1, includes a housing 12 and is operable with two hand-held contact probes 14 and 16. Contact probe 14 is desirably the "cold" probe and will be contacted with the negative or ground test point, while probe 16 is desirably the "hot" probe and will be contacted with the positive test point. The term "test point" is used simply to identify any point on a circuit or component it is desired to test.

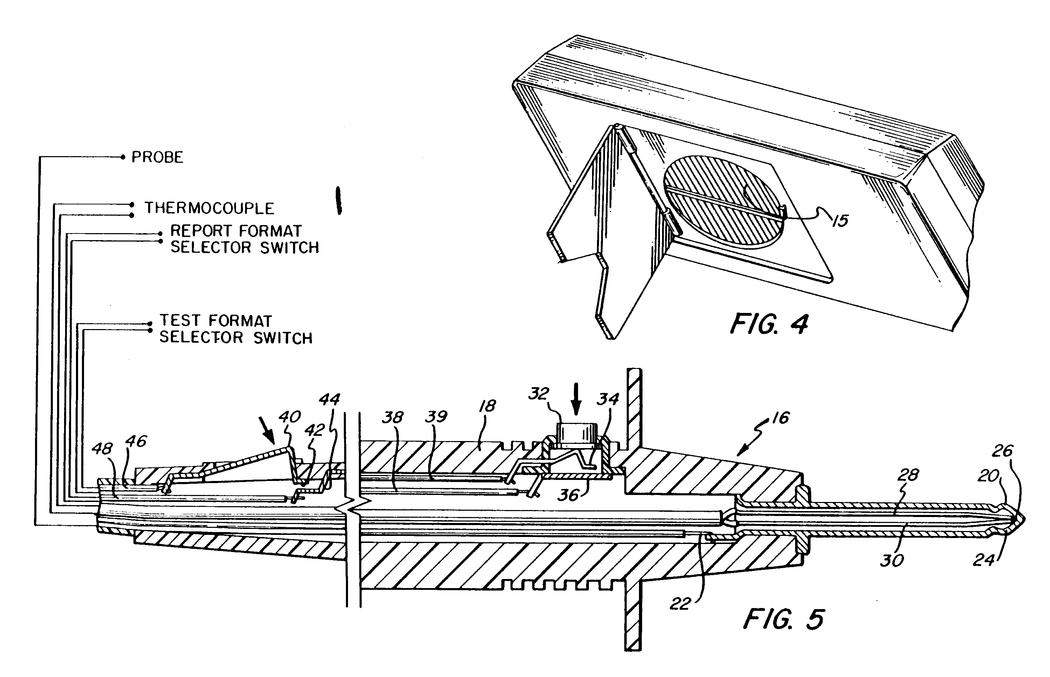

Reference to Figure 5 shows probe 16 foreshortened and partially cut away to reveal the detail of construction. Shaft 18 is constructed of a suitable plastic material and has a metallic contact 20 mounted at its front end. Contact 20 is adapted for electrical connection to the meter by means of conductor 22 and has a hollow interior which holds another sensor such as thermocouple 26, which can be of any suitable type and construction. Leads 28 and 30 extend from the thermocouple 26 for connection to the meter. The probe 16 is also shown to include two switches 32 and 40 at least one of which, preferably 32, is located so as to be operable by hand, while the contact probe 16 is held in the locale of a test point.

In the embodiment shown, these switches 32, 40 can provide a stimulus to selector means from a point remote from the meter itself to cause the meter to operate in a desired test and/or report format. The selector means, which preferably comprises a microprocessor programmed to direct meter operation in response to remote stimuli and switch means on the meter will be described in detail below.

While the device is shown as providing remote stimulus by means of electrical contact switches on the probe, other remote stimuli can be employed, including: proximity switches; electromagnetic stimuli such as radio waves, heat, light, (visible, ultraviolet, and infrared) can actuate switching devices responsive to them; sonic stimuli such as voice, clickers, whistles, or other stimuli (audible and inaudible) can actuate switching devices responsive thereto; and other sources of remote stimuli capable of transmitting a switching signal, e.g., remote telephones can provide stimuli and receive reports.

Switch 32 is shown here as a button-type, normally-open contact switch having contacts 34 and 36 electrically connected to leads 38 and 39 which enable connection to the meter. Switch 40 is shown also as a normally-open contact switch, including contacts electrically connected to leads 46 and 48 which enable connection to the meter. Preferably, of these switches, 32 is coupled to the selector means to control test format and the other, e.g. 40, is similarly coupled to control report format. In the preferred embodiment, the switches will be operable without setting the probe down. For example, switch 32 can be located for ease of operation by the index finger and switch 40 for operation by the thumb.

Control of test and/or report format by the operator at the point of test, remote from the location of the meter, is extremely advantageous. The term "test format" is defined to mean a testing routine which requires a combination of variables including identification of the parameter to be tested, the scale to be used, and any other function defining a test procedure which is required by the meter circuitry to accurately measure and report test results. The term "report format" is defined as a routine for reporting a combination of variables including identification of the parameter being tested, the scale range, any warnings or special procedures to be followed, the frequency of reporting, the number of significant figures reported and the sequence of reporting these and other variables which are significant to yield a clear and concise report with sufficient detail under the circumstances.

As will be described later, means, typically ROM chips, are provided to store a plurality of different report formats which can be accessed by the selector means in response to remote stimulus or on-meter switching means. Upon command from the selector means, the desired test and/or report formats are directed to a microprocessor to cause the meter to function in the desired test and/or report format. As will be described later, reporting can be by a visual display, or by an audible signal such as synthesized speech via speaker 15 shown in Figure 4, or a combination of these. However, the visual display, such as LCD shown as 13 in Figure 1, will most typically be controlled to operate in a standard format, which, for example, indicates the parameter being measured, the range scale, whether AC or DC current is involved, and the full complement of digits capable of display.

Referring now to Figures 2 and 3, a preferred combination of female and male connectors for utilization with contact probe 16 shown in Figure 5 is shown. Male connector 100 has male member 122 for electrically connecting the probe 20 to the meter via mating with the female connector 200 at plug receptacle 222. Male members 128 and 130 are preferably sized as conventional thermocouple male connectors and electrically connect the thermocouple 26 to slots 228 and 230 on female connector 200. Similarly, male members 238 and 239 electrically connect the test format selector switch to the meter. And, male members 146 and 148 mate with female members 246 and 248 to electrically connect the report format selector switch to the meter. Sleeve 150 has key 152 to assure proper alignment of the male plug 100 into female receptacle 200 by mating with hole 250 having keyway 252. Receptacle 254 can receive a standard male probe plug for high amperage tests.

It is an advantage of the particular female connector 200 shown that it can be employed with specialized male connector 100 or can receive a conventional thermocouple male connector if this is desired, say where a specialized thermocouple is required, and it can also receive a standard test probe male connector where this is desired.

By operating the remote test mode selector switch, the selector means is stepped through a predetermined sequence of test formats; for example, first AC or DC, then ohms, then amps, then voltage and then temperature. Where, as in the preferred embodiment of the invention, the meter is of the autoranging type, there will be no need to select range of scale manually. However, the microprocessor of the selector means can be programmed to step through various scale ranges by, say giving two switching pulses in rapid succession.

Manual on-meter electronic test format selector switches are also provided for any of the same test formats controlled by selector switch 32 as well as for different test formats, as is desired. The test format switch panel 300 on the meter in Figure 1 is preferably a membrane panel enabling electronic switching without more complex and costly mechanical switches. Panel 300 shows eight test formats on switch pressure points. These enable testing for amperage on the 20 milliamp (20 ma), and 200 milliamp (200 ma) and 10 amp (10a) scales, ohms ($\Omega$), voltage (V), temperature in degrees Celsius (°C), either AC or DC ($\frac{AC}{DC}$), or for circuit continuity

$$( \rightarrow\!\!\vdash ).$$

it will be possible of course to program for selection of any other desired test formats. It is desirable to display the test format selected on the visual display 13, and also to supply this information for selection as required by various audible reports formats.

In addition to the panel 300, button-type switches 302, 304 306 and 308 are provided for various meter control functions. Switch 302 can, for example, be a power switch; 304 can lock the visual display on any current display; 306 can lock the meter on a particular report format; and 308 can lock the meter on a particular report format; and 308 can lock the meter on a particular test format.

Panel 400 is similar in construction to panel 300 and is shown to provide eight selector switches for selecting the desired report format. As shown, there is a memory switch (M) which causes any sequence of test reports to be stored, to the capacity of the memory, on a first-in-first-out basis, for alter review and recording. The meter will, when in the delta format ($\Delta$), report any change in test format selected by the operator or directed by the autoranging meter. In the timed report format (T), a test reading can be repeated, say every five seconds, to test for drift or other change in magnitude; in the single report format (S), the meter will delay a fixed amount of time, say 1 or 2 seconds, for the test reading to stabilize and then give a single report, without repeating it. Alternatively, in the single report format, the test signal can be tested electronically to assure its stability prior to giving the single report. The remaining switches (1), (2), (3), and (4) on report format selection panel 400 enable selecting the number of significant digits for the report. Any of the formats can also provide caution and override messages to the operator where damage to the meter or circuit may be possible or where an incompatible series of instructions was given as to test format and the microprocessor has caused override of the instructions.

It is also desired to include a suitable interface such as a telephone jack and/or a RS 232 port for enabling receiving test and report format instructions and transmitting test results or warnings. For example, a telephone call can be initiated by the meter where an ongoing test with fixed probes senses a predetermined desired or undesired value or condition. The report can be made by speech with the remote operators having the ability to give further instructions. Also the test information can be continuously or periodically transmitted to a computer for storage and/or analysis.

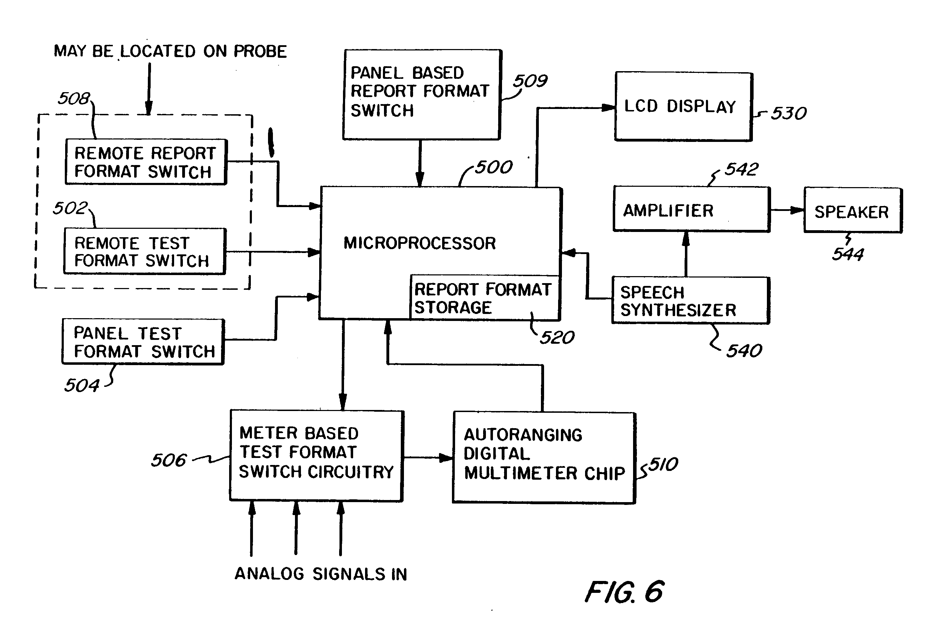

Reference is now made to Figure 6 which shows a block diagram representing the interrelations of basic circuit components for a preferred form of the invention. Centrally located in Figure 6 is a microprocessor 500 which is programmed preferably: to receive signals from test format switching means including remote 502 and local 504 (on the meter housing) switches generate a test format selection signal, and send the test format selection signal to a meter circuit 510 to cause the meter to operate in the selected format (the meter will preferably include internal test format switching circuitry 506 to select the appropriate analog input from test probes or other input device on instructions from the microprocessor); to receive a meter output signal indicative of a measured value of a parameter and generate a report signal according to a selected report format; to receive signals from report format switching means, both remote 508 and local 509, generate a report format selection signal, and send the format selection signal to means 520 which store a plurality of report formats to cause the selected report format to be directed to the microprocessor; to receive the selected report format and generate a report signal according to the selected report format; and to generate a signal indicative of the desired report and send that signal to a visual display 530 and/or a speech synthesizer 540 to audibly report the test results as synthesized speech in the selected report format. A microprocessor, such as an NEC 7503 can be employed.

Suitable as the speech synthesizer is a 7759 available from NEC. Preferably, replaceable ROM chips, such as an NEC 23C100, will be employed to enable the speech synthesizer to operate in any of a number of desired languages. The speech synthesizer will receive a signal indicative of the desired report and transmit it to the speech synthesizer which in combination with an amplifier 542 and speaker 544 will audibly report test results and other desired test information in the selected report format and the desired language. The term "speaker" is meant in its generic sense and includes all electroacoustical transducers effective for reporting audible speech and includes such devices and earphones and the like. If desired, a simple on-off switch can be operated on the meter or remotely to turn the speaker on and off as desired.

The various report formats are burned into means 520 which can comprise ROM chips as above or those on board the processor as above.

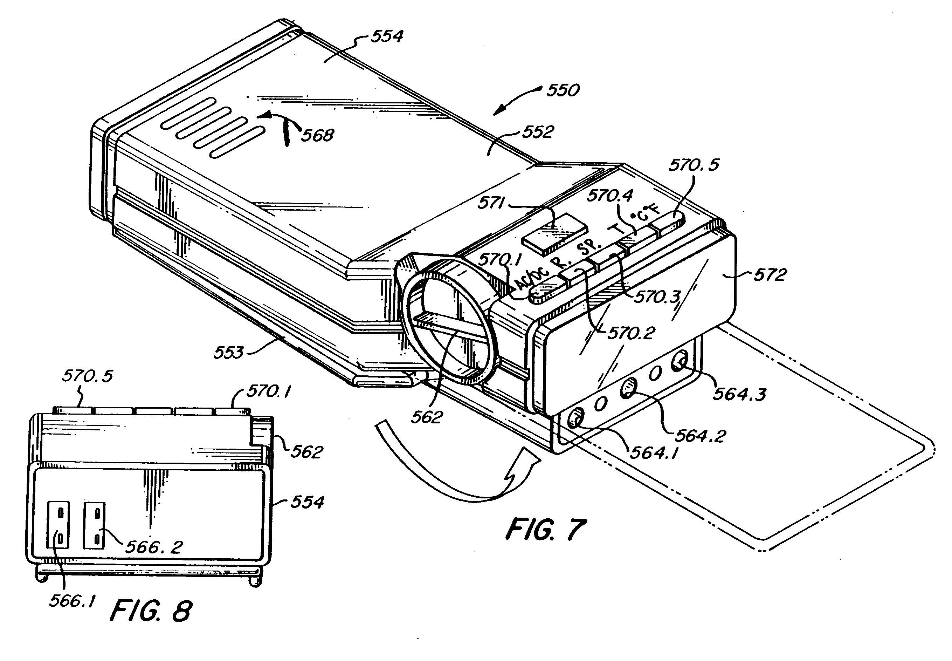

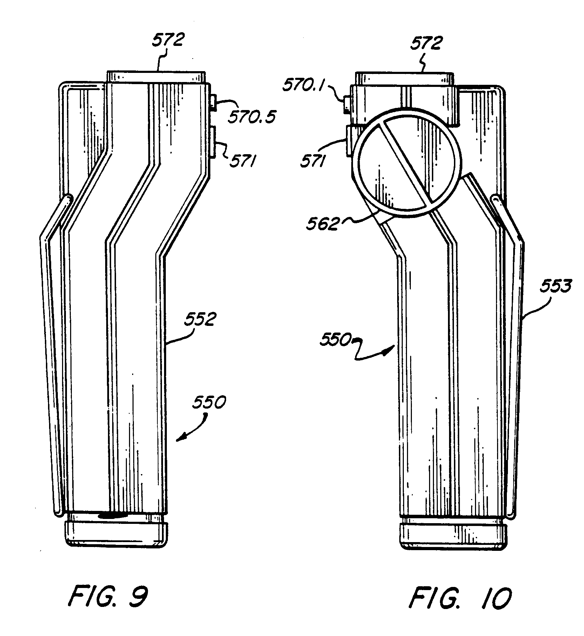

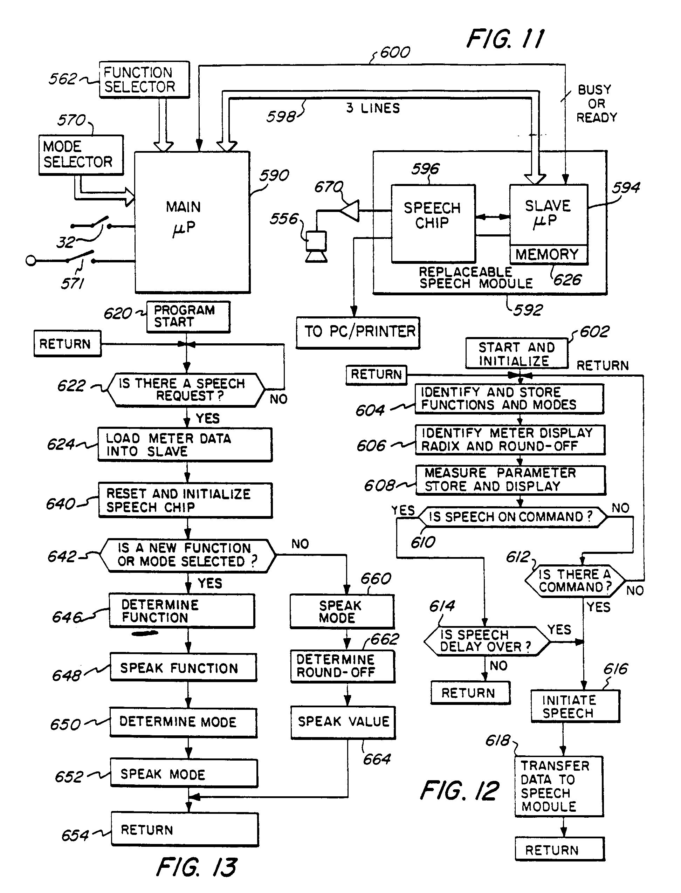

Figures 7 through 10 show another form for a speaking test meter 550 in accordance with the invention. Meter 550 has a generally rectangular crossection housing 552 formed with a first portion 554 containing a speaker 556 (see Figure 11) behind a slotted segment 558. Another portion 560 includes controls provided in the form of a rotary function selector 562 connected to the pole of a multiple position switch inside housing 552. The function selector 562 enables the generation of unique function signals by which meter 550 can measure temperature, millivolts, volts, ohms, milliampers and amperes. For these functions, probes such as 14 and 16 of Figure 1 are inserted into probe connectors 564.1-564.3. Temperature is measured with one or several thermocouple probes that are connected to temperature receptacles 566.1 and 566.2 at the rear of housing 552. A pivoting handle 553 is provided. Meter 550 has an auto-ranging capability.

In the various function settings of function selector 562 different operating modes are provided with mode selection switches 570.1 thorough 570.5 located above a digital, four decimal digit display 572. The mode switches 570 provide, by respective repeated actuations, an AC or DC mode with switch 570.1; a temperature selection with switch 570.4 using a single thermocouple T1 or T2, or the difference T1-T2 between them; a centigrade or Fahrenheit temperature scale selector with switch 570.5; a continual speech pattern, or one that operates on command only or one that operates at selected intervals by switch 570.3 and a display round-off selector 570.2 with which one can limit the display to the right of the decimal or radix point. As explained below, the displayed digits are the ones that are spoken. Selection of anyone mode with any one switch can be done with repeated actuations that cycle through all the modes controlled by the switch. A speech request signal generating switch 571 is provided to stimulate a speaking of a value at the meter. A commonly available multimeter chip is employed such as the Max 133 made by the Maxim Corporation.

In the embodiment of Figures 7-10, the test meter's speaking capability is made particularly suitable for adaptation to different languages. This is done by incorporating, as shown in Figure 11, in addition to a main microprocessor 590, a replaceable speech module 592. The speech module 592 includes a slave microprocessor 594 and a speech chip 596. The speech chip stores the digital samples of various words that need to be spoken in order to enunciate the meter functions, modes and parameter values through speaker 556. The speech chip is a standard device, such as the NEC 7554 and responds to the control signals from the slave microprocessor 594. The latter in turn operates to translate the meter data to be pronounced into signals that then can cause the speech chip to pronounce the meter data in the proper way.

Hence, processor 594, being a replaceable device with chip 596, can be programmed with the rules of the specific language to be spoken while the test meter with its main processor 590 can remain the same. This simplifies the test meter 550 while still accommodating the various language complexities that are encountered.

Communication between the main processor 590 and the speech module 592 is obtained along a serial port 598 with the aid of control lines and a busy or ready control line 600. Data is transferred from the main processor 590 in a fixed serial train of bit pulses whenever the meter 550 requires a spoken format.

The operation of main processor 590 is generally set forth in the steps illustrated in Figure 12. Various automatic operations are performed, some of which are well-known. Thus, at 602 various flags, registers and memory locations are reset or set to initial values. At 604 various selected meter functions and modes are stored and the occurrence of a new selection by the operator is noted by setting an appropriate flag. The display settings are identified at 606 along with a suitable round-off number that corresponds to how many digits are to be displayed.

Ordinarily, test meter 550 can display parameter values in four digits. For example, in a lower scale, one digit can be on the left of the decimal point and three on the right. In measuring and speaking of a parameter, however, the operator may only be interested in two of the digits, namely, the one to the left and the one to the right of the decimal point and hearing the meter speak all four digits can be both bothersome and unnecessary.

In the meter of this invention, therefore, the operator can select a display of desired digits by producing a round-off signal with mode switch 170.2. Actuation of this switch successively, cycles the display through a showing of one, two, or three digits to the right of the decimal point, depending upon the scale. The main microprocessor 590 identifies this round-off number at step 606.

At 608 the parameter of interest is measured and its value stored and displayed. A test is then made at 610 whether a spoken format of the parameter measurement is required only upon command as selected with mode switch 570.3, such command is generated when the probe switch 32 or switch 571 is actuated, see Figures 5 and 11. If so, the presence for such command is tested for at 612. In the absence of a command, a return is made to step 604.

If a command is present or if a speech request arises because the regular interval between such requests, as selected by mode switch 570.3, has terminated as tested at 614, then a speech routine is entered at 616. Meter data is transferred at 618 to the speech module 592 and a return is made to step 604.

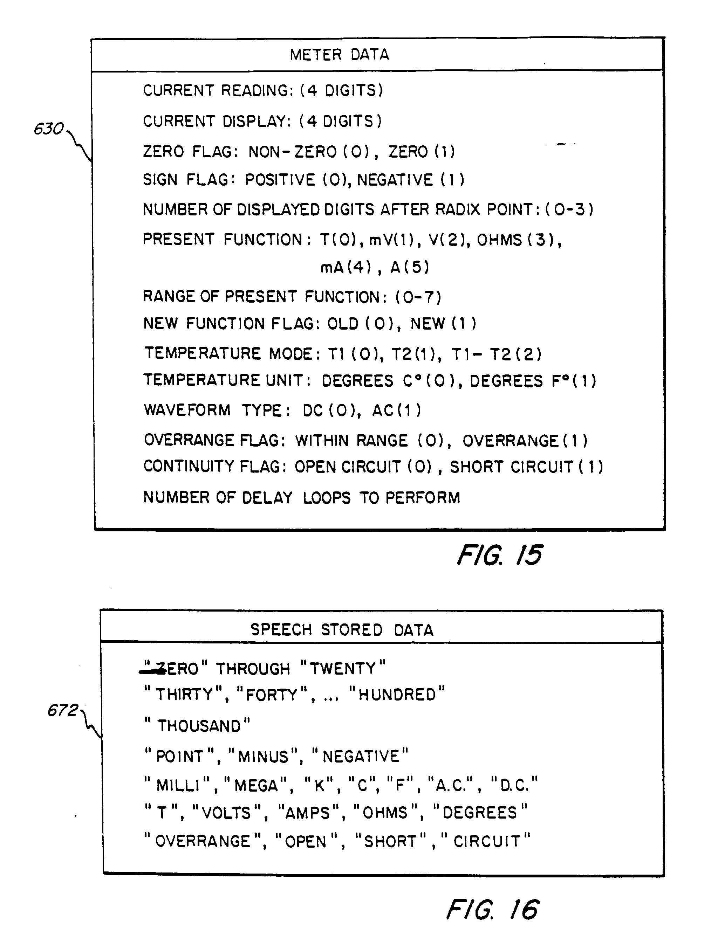

The slave microprocessor 594 of Figure 11 is programmed with a read only memory to respond when requests are made for a speech command. The processor 594 operates as illustrated in Figure 13, starting at step 620 with various program start up routines including resets, flag setting, etc. At 622 a test is made whether a request for speaking has been received from the main processor 590. If not, the slave processor continues in this waiting mode. If so, however, data from the main processor 590 including the most recent measurements are transferred at 624 into slave processor memory 626. The data transferred consists of the information as set forth at 630 in Figure 15 and is transferred in serial format into memory 626 in Figure 11. In response the slave microprocessor 594 sends a busy signal on line 600 (see Figure 11) and commences at 640 in Figure 13 with a resetting and initializing of the speech chip 596.

At 642 the new function flag received from processor 596 is checked for whether the operator had selected a new function or a new mode. If so, the current function is identified at 646 and the speech chip instructed to audibly speak the function at 648. At 650, the current mode is identified and its spoken format occurs at 652. A return is then made at 654 to await the next speech request at 622.

In this manner, an operator can cause a change in function or mode without also causing a probably meaningless speaking of a measurement since the probes probably have not yet been applied to appropriate test points.

In the event no new function or mode was selected as determined at 642, the processor 594 proceeds to instruct the speech chip 596 to speak the current mode at 660 and at 662 the value of the measurement in accordance with the round-off in effect for the display is identified and this value is spoken at 664. A return is then made to await a speak request at 622.

The speech chip 596 is provided with digital words representative of digitized samples of analog speech of the words needed to compose all of the test meters functions, modes and measurements. The speech produced by the chip then includes combinations of the words in the sequence as called out by processor 594. The words are recomposed into an analog form by a d/a converter whose output is applied to an amplifier 670 (see Figure 11) coupled to drive speaker 556.

Figure 16 shows at 672 the words stored in speech chip 596. These include the whole integers from zero through twenty, the decades through ninety, and those others as shown. The rules of speech then cause these words to be combined to say for example "two hundred fifty six point three ohms" for a measurement of 256.3 ohms.

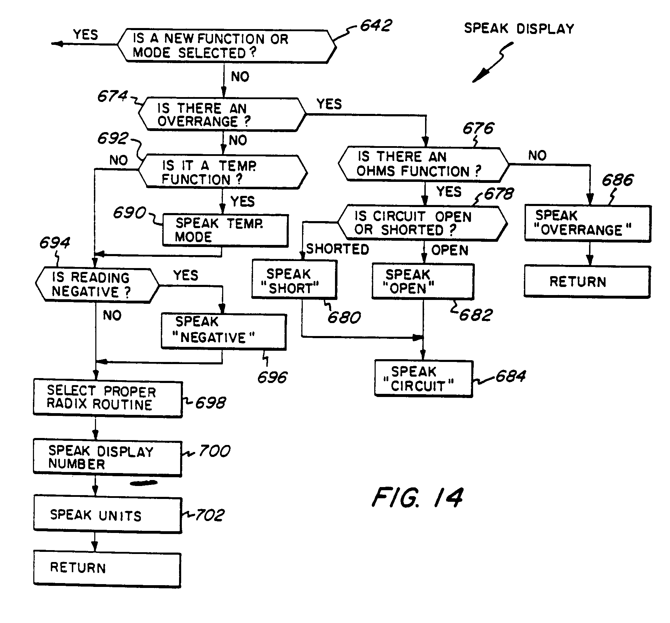

Figure 14 illustrates slave processor 594 steps with greater detail. After test 642 determines that for an existing function and mode, a new measurement is to be spoken, a test is made at 674 whether an overrange condition occurred. This test involves examining the overrange flag shown in Figure 15 and corresponds to either an excessively high or low measurement by the main processor 590. If so, the next test at 676 is whether resistance is being measured so that a subsequent test at 678 can determine whether this is a short circuit or open circuit condition. The corresponding words are spoken at 680 or 682, and 684 before a return is made to step 622 in Figure 13.

If no resistance is being measured "overrange" is spoken at 686 and a return is made to 622 in Figure 13.

If no overrange condition exists then, after speaking the temperature mode at 690 after test 692, a test is made at 694 for negative measurements by checking the sign flag in Figure 15. If negative, that word is spoken at 696.

At 698, the proper radix routine is selected so that at 700 the number actually shown in the display can be spoken. The units represented by the number are then spoken at 702 and a return is made to step 622 in Figure 13.

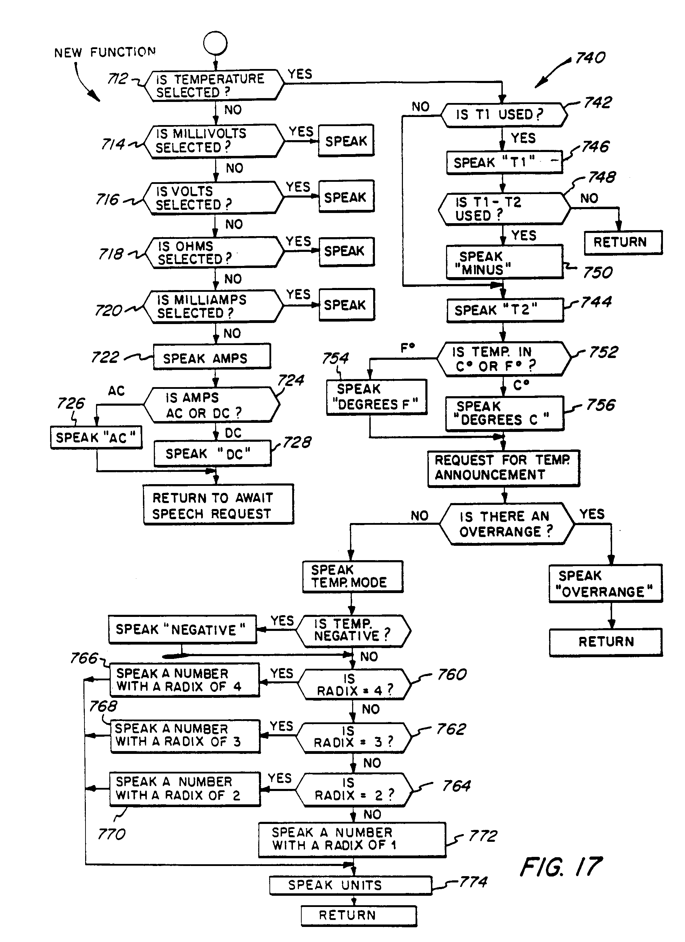

Figure 17 illustrates the portion of Figure 13 in greater detail for the case where a new function is selected. Detailed illustrative steps are shown for the case where temperature is the new function, followed by another speaking request to illustrate the speaking routine for a particular temperature measurement.

At 712 a test made whether the new function, as identified by the new function flag, is temperature. If not, a test is made at 714 whether the new function is millivolts. This continues at tests 716, 718 and 720 for the functions as noted, until by process of elimination the new function must be amperes. This is spoken at 722 and after DC or AC modes are identified at 724 the modes are spoken at 726 or 728. Note that the other functions are handled in a similar manner.

When temperature is the new function or new mode, a routine at 740 is entered to first speak the temperature mode. Thus at 742 a test is made whether a thermocouple at the T1 port is used. If not, then the "T2" mode is spoken at 744. However, if this thermocouple is used, then after T1 is spoken at 746 and a test at 748 confirms that the difference mode T1-T2 is used, the word "minus" is spoken at 750 followed by "T2" at 744.

At 752 a test is made whether temperature is being measured in centigrade or Fahrenheit and the appropriate mode is pronounced at 754 or 756.

If after a new temperature function or mode has resulted in an announcement, then following the steps as shown, tests are made at 760, 762 and 764 to determine the radix being employed in the display. In each case where that display radix is identified, an appropriate number is spoken according to the routines 766, 768, 770 and 772, followed by the speaking of the units for that measurement at 774, in this case ° C or ° F.

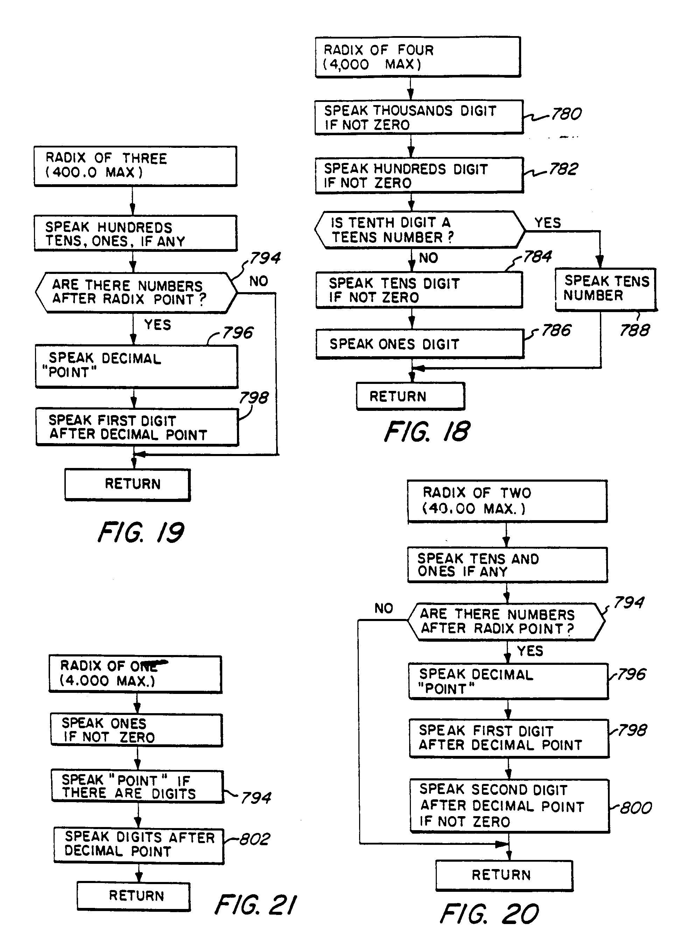

Figures 18 through 21 illustrate the number speaking routines employed with different radices. In case of a radix of four (see Figure 18) a number in the thousand can be spoken at 780, unless it is zero. Then the hundreds digit is spoken at 782 unless it is zero, and a tens digit at 784 if that is not zero until at 786, a ones digit is spoken. Note the exception for a teens number which is spoken at 788 if needed while subsequently skipping the tens and ones digits.

The number speaking routine thus follows the rules that are peculiarly applicable to the English language. If another language is used, a different number speaking routine probably would be needed.

In the Figures 19-21 a test is also made whether numbers occur after the radix decimal point since the meter does provide four digit measurements. Thus at 794 a test is made whether there are digits after the radix point as shown in the main processor data in Figure 15. If there is such digit, the decimal "point" is spoken at 796 followed at 798 by the first digit after the decimal point.

In Figure 20 for a radix of two there can be two digits after the decimal point, but the second digit is not spoken if it is zero as determined at 800. In Figure 21 all digits present in the display to the right of the decimal point are spoken at 802.

The above description is for the purpose of teaching the person or ordinary skill in the art how to practice the present invention, and it is not intended to detail all those obvious modifications and variations of it which will become apparent to the skilled worker upon reading the description. It is intended, however, that all such obvious modifications and variations be included within the scope of the present invention which is defined by the following claims.

## Claims

1. A test meter (10) arranged for testing a plurality of measurable parameters, including indicating means (13,15) for giving a user a respective indication of each of said parameters, an independently locatable and movable probe (16) for sensing a parameter and providing a test signal to the meter indicative of that parameter, control means (300,400,570) by which the user is able to cause the meter(10) to give said respective indications, and selector means (502,504,509) responsive to electrical signals caused to be generated by the user on an electrical lead, for changing the format of a report produced by the test meter (10) through a plurality of different formats in a predetermined sequence and for changing the formats of test parameters used by the test meter through a plurality of different formats in a predetermined sequence, characterised in that the probe (16) has an extended multi-conductor lead (22,28,30,38,39,46,48) detachably connected to the test meter (10); one of the conductors (38,39) in the multi-conductor lead (22,28,30,38,39,46,48) being coupled to a first switch means (508,509) of the selector means and another one (46,48) of the conductors in the multi-conductor lead (22,28,30,38,39,46,48) being coupled to a second switch means (502,504) of the selector means; the probe (16) having a first control switch (32) coupled to send an electrical signal on the said one conductor (38,39) in the lead (22,28,30,38,39,46,48) so as to operate the first switch means (508,509) to change the report format of the test meter (10); and the probe (16) having a second control switch (40) coupled to send an electrical signal on the said other conductor (46,48) in the lead (22,28,30,38,39,46,48) so as to operate the second switch means (502,504) to change the test parameter format of the test meter (10).

2. A test meter as claimed in Claim 1 characterised in that said probe (16) further includes a thermocouple (26) for sensing temperature, the thermocouple leads (28,30) being coupled to the test meter through additional conductors in said multi-conductor lead (22,28,30,38,39,46,48).

3. A test meter as claimed in Claim 1, characterised in that said indicating means (13,15) includes audible reporting means (15) for audibly reporting said parameters.

4. A test meter as claimed in Claim 3, characterised in that said first switch means enables control of said audible reporting means (15).

5. A test meter as claimed in Claim 3 or 4, characterised in that said audible reporting means (15) for audibly reporting test information comprises; speech synthesizer means (540,596), microprocessor means (500,590) programmed to function with the speech synthesizer means (540,596) and an amplifier (542,670) and speaker (544) to report said parameters as speech.

6. A test meter as claimed in Claim 5, characterised in that said audible reporting means (15) for audibly reporting test information further comprises electronic means (520) for storing said plurality of report formats.

7. A test meter as claimed in Claim 1, characterised by being capable of reporting test results as speech in any one of a plurality of selectable report formats, and by further comprising; microprocessor means (500,590) for controlling the reporting of test results as speech; means for receiving a test signal generating a meter output indicative of a measured value of a parameter, and directing said meter output to said microprocessor means (500,590); means (520) for storing a plurality of selectable report formats and directing a selected one to said microprocessor means (500,590); and a speech synthesizer (540,596); wherein said first switch means selectively causes a particular report format to be directed to said microprocessor (500,590); and said microprocessor means (500,590) is programmed to receive said meter output and cause a speech synthesizer (540,596) to audibly report test results in a selected format.

8. A test meter as claimed in Claim 7 characterised in that the detachable connection (100,200) of said probe (16) to said test meter includes connection to said means for receiving test signals and the probe (16) is configured for being held and positioned by hand and the first and second control switches (32,40) are operable by hand while the probe (16) is held in contact with a desired test point.

9. A test meter as claimed in Claim 8 characterised in that the probe (16) further includes a means (26) for sensing temperature coupled through the multiconductor lead (22,28,30,38,39,46,48) to one half (100) of a separable connector in common with conductors for other components of the probe (16), and the meter includes on a housing (12) a mating half (200) of a separable connector which is configured to receive the one half (100) of said connector thereby detachably coupling said multi-conductor lead (22,28,30,38,39,46,48) to said meter.

10. A test meter as claimed in any preceeding claim, characterised in that the probe (16) comprises a contact probe (20) configured for being held and positioned in the locale of a desired test point by hand and the control switch means (32,40) are operable by hand while the probe (16) is held in contact with a desired test point.

11. A test meter as claimed in Claim 1, characterised in that said selector means comprises a microprocessor means (500,590), operably responsive to said remote electrical signals (502,508) caused to be generated by the operator as well as to electrical signals provided by said second switch means (504,509) located on the meter, for causing the meter to operate in any one of the plurality of test parameter formats and in any one of the said plurality of report formats; an autoranging multimeter circuit (510) capable of generating a meter output responsive to the test signal and thus indicative of a measured value of a parameter, and directing the meter output to the microprocessor means (500,590); the microprocessor means (500,590) including means (520) for storing said plurality of report formats and directing a selected one to a speech synthesizer means (540,596) to cause the speech synthesizer means to audibly report test results in a selected format.

12. A test meter as claimed in Claim 11, characterised in that electronic means (506) are further provided for storing a plurality of test formats and for directing a selected one of the test formats to the autoranging multi meter circuit (510); and the microprocessor means (500) is programmed to cause the speech synthesizer (540,596) to audibly report a test format message in response to selection of a given test format.

13. A test meter as claimed in Claim 11 or 12, characterised by slave microprocessor means (594) operatively connected to the microprocessor means (500,590) and including means (626) for storing words to be audibly reproduced in a desired language and representative of the various measurements, functions and modes related to parameters that can be measured and displayed by the meter; the slave microprocessor means (594) being effectively coupled between the first microprocessor means (500,590) and the speech synthesizer (540,596) for delivering, as determined by said plurality of meter data signals from the microprocessor means (500,590), a plurality of command signals to the speech synthesizer (540,596) to cause the latter to generate audible reproductions of selected ones of said plurality of meter data signals in conformance with rules applicable to said desired language.

14. A test meter as claimed in Claim 13, characterised in that the slave microprocessor means (594) and the speech synthesizer (540,596) together define a speech module (592) which is detachable and replaceable independently of the microprocessor means (500,590).

15. A test meter as claimed in Claim 13 or 14, characterised in that the microprocessor means (500,590) is further capable of generating speech request signals on demand; and the slave microprocessor means (594) includes means responsive to a speech request signal from the microprocessor means for initiating the delivery of said plurality of command signals to the speech synthesizer (540,596).

16. A test meter as claimed in Claim 15, characterised by directing means in the microprocessor means (500,590) for delivering, effectively in response to a speech request signal the said plurality of meter data signals to the slave microprocessor means (594).

17. A test meter as claimed in Claim 16, characterised by means in the speech synthesizer (540,596) for storing speech rule signals for determining a sequence of command signals needed to produce said audible reproductions compatible with the desired language.

18. A test meter as claimed in any one of Claims 13 to 17, characterised by electronic means for selecting a desired display resolution of parameter measurements and producing a round-off signal indicative thereof; and electronic means responsive to the round-off signal for controlling the selection of said command signals to establish an audible pronunciation of the displayed parameter measurement.

19. A test meter as claimed in Claim 18, characterised by means for rounding-off displayed parameter measurements to a desired place on the right side of the decimal point and generating said round-off signal indicative thereof.

20. A test meter as claimed in Claim 19, characterised in that the plurality of meter data signals that are delivered to the microprocessor means (500,590) include said round-off signal.

21. A test meter as claimed in Claim 19, characterised by means for generating a first temperature signal representative of a measurement with a first temperature probe; means for generating a second temperature signal representative of a measurement with a second temperature probe, and means for generating a signal representative of the difference between the first and second temperature signals.

**Patentansprüche**

1. Prüfmeßgerät (10) zum Prüfen einer Vielzahl von meßbaren Parametern mit Anzeigeeinrichtungen (13, 15), die einem Benutzer die jeweilige Anzeige eines jeden Parameters angeben, mit einem unabhängig anordbaren und bewegbaren Tastkopf (16) zur Erfassung eines Parameters und zur Versorgung des Meßgerätes mit einem für den Parameter bezeichnenden Testsignal, mit einer Steuereinrichtung (300, 400, 570), durch welche der Benutzer das Meßgerät (10) zu den jeweiligen Anzeigen veranlassen kann, und mit einer Wähleinrichtung (502, 504, 509), die auf durch den Benutzer in einem elektrischen Kabel erzeugte elektrische Signale anspricht, um das Darstellungsformat, welches durch das Prüfmeßgerät (10) aus einer Vielzahl von verschiedenen Formaten in einer vorher festgelegten Reihenfolge erzeugt wird, zu ändern und um die Formate der Testparameter, welche vom Prüfmeßgerät aus einer Vielzahl von verschiedenen Formaten in einer vorher festgelegten Reihenfolge genutzt werden, zu ändern,
dadurch gekennzeichnet, daß der Tastkopf (16) ein erweitertes mehradriges Kabel (22, 28, 30, 38, 39, 46, 48) aufweist, welches lösbar mit dem Prüfmeßgerät (10) verbunden ist, wobei eine der Leitungsadern (38, 39) im mehradrigen Kabel (22, 28, 30, 38, 39, 46, 48) mit einer ersten Schalteinrichtung (508, 509) der Wähleinrichtung gekoppelt ist und eine andere (46, 48) der Leitungsadern im mehradrigen Kabel (22, 28, 30, 38, 39, 46, 48) mit einer zweiten Schalteinrichtung (502, 504) der Wähleinrichtung gekoppelt ist, wobei der Tastkopf (16) einen ersten Steuerschalter (32) aufweist, der bei Kontakt ein elektrisches Signal auf die eine Leitungsader (38, 39) im Kabel (22, 28, 30, 38, 39, 46, 48) legen kann, um die erste Schalteinrichtung (508, 509) zu betätigen und das Darstellungsformat des Prüfmeßgerätes (10) zu ändern, und wobei der Tastkopf (16) einen zweiten Steuerschalter (40) aufweist, der bei Kontakt ein elektrisches Signal auf die andere Leitungsader (46, 48) im Kabel (22, 28, 30, 38, 39, 46, 48) legen kann, um die zweite Schalteinrichtung (502, 504) zu betätigen und das Testparameterformat im Prüfmeßgerät (10) zu ändern.

2. Prüfmeßgerät nach Anspruch 1, dadurch gekennzeichnet, daß der Tastkopf (16) des weiteren ein Thermoelement (26) zur Temperaturerfassung aufweist, wobei die Thermoelementkabel (28, 30) mit dem Prüfmeßgerät über zusätzliche Leitungsadern im mehradrigen Kabel (22, 28, 30, 38, 39, 46, 48) verbunden sind.

3. Prüfmeßgerät nach Anspruch 1, dadurch gekennzeichnet, daß die Anzeigeeinrichtungen (13, 15) eine akustische Ausgabeeinrichtung (15) zur akustischen Ausgabe der Parameter aufweisen.

4. Prüfmeßgerät nach Anspruch 3, dadurch gekennzeichnet, daß die erste Schalteinrichtung eine Steuerung der akustischen Ausgabeeinrichtung (15) ermöglicht.

5. Prüfmeßgerät nach Anspruch 3 oder 4, dadurch gekennzeichnet, daß die akustische Ausgabeeinrichtung (15) zur akustischen Ausgabe von Testinformationen einen Sprachsynthesizer (540, 596), einen Mikroprozessor (500, 590), der für das Zusammenwirken mit dem Sprachsynthesizer (540, 596) programmiert ist und einen Verstärker (542, 670) sowie einen Lautsprecher (544) zur sprachlichen Ausgabe der Parameter aufweist.

6. Prüfmeßgerät nach Anspruch 5, dadurch gekennzeichnet, daß die akustische Ausgabeeinrichtung (15) zur akustischen Ausgabe von Testinformationen des weiteren eine elektronische Einrichtung (520) zum Speichern einer Vielzahl von Darstellungsformaten aufweist.

7. Prüfmeßgerät nach Anspruch 1, dadurch gekennzeichnet, daß das Prüfmeßgerät Testergebnisse sprachlich in einem von einer Vielzahl von wählbaren Darstellungsformaten ausgeben kann und daß des weiteren ein Mikroprozessor (500, 590) zur Steuerung der sprachlichen Ausgabe von Testergebnissen, eine Einrichtung zum Empfang eines Testsignals, die ein für einen gemessenen Parameterwert bezeichnendes Meßgeräteausgangssignal erzeugt und den Mikroprozessor (500, 590) mit dem Meßgeräteausgangssignal beaufschlagt, eine Einrichtung (520) zum Speichern einer Vielzahl von wählbaren Darstellungsformaten und zum Beaufschlagen des Mikroprozessors (500, 590) mit einem gewählten Darstellungsformat und ein Sprachsynthesizer (540, 596) vorgesehen sind, wobei die erste Schalteinrichtung den Mikroprozessor (500, 590) selektiv mit einem besonderen Darstellungsformat beaufschlagt und der Mikroprozessor (500, 590) dazu programmiert ist, das Meßgeräteausgangssignal zu empfangen und den Sprachsynthesizer (540, 596) zur akustischen Ausgabe der Testergebnisse in einem gewählten Format zu veranlassen.

8. Prüfmeßgerät nach Anspruch 7, dadurch gekennzeichnet, daß die lösbare Verbindung (100, 200) des Tastkopfes (16) mit dem Prüfmeßgerät eine Verbindung zur Empfangseinrichtung für Testsignale beinhaltet und daß der Tastkopf (16) per Hand gehalten und positioniert werden kann und der erste sowie der zweite Steuerschalter (32, 40) per Hand betätigt werden können, während der Tastkopf (16) mit einem gewünschten Testpunkt in Kontakt gehalten wird.

9. Prüfmeßgerät nach Anspruch 8, dadurch gekennzeichnet, daß der Tastkopf (16) des weiteren eine Einrichtung (26) zur Temperaturerfassung aufweist, die über das mehradrige Kabel (22, 28, 30, 38, 39, 46, 48) mit einer Hälfte (100) des lösbaren Verbindungsstückes zusammen mit Leitungsadern für andere Komponenten des Tastkopfes (16) gekoppelt ist und daß das Prüfmeßgerät in einem Gehäuse (12) die entsprechende Hälfte (200) des lösbaren Verbindungsstückes beinhaltet, welche zur Aufnahme der einen Hälfte (100) des Verbindungsstückes ausgebildet ist, wodurch das mehradrige Kabel (22, 28, 30, 38, 39, 46, 48) mit dem Prüfmeßgerät lösbar verbunden ist.

10. Prüfmeßgerät nach einem der vorangehenden Ansprüche, dadurch gekennzeichnet, daß der Tastkopf (16) einen Kontaktkopf (20) aufweist, der mit der Hand gehalten und an die Stelle eines gewünschten Testpunktes plaziert werden kann, und daß die Steuerschalter (32, 40) mit der Hand betätigbar sind, während der Tastkopf (16) mit einem gewünschten Testpunkt in Kontakt gehalten wird.

11. Prüfmeßgerät nach Anspruch 1, dadurch gekennzeichnet, daß die Wähleinrichtung einen Mikroprozessor (500, 590), der sowohl auf elektrische Fernsignale (502, 508), die durch einen Benutzer erzeugt werden, als auch auf elektrische Signale anspricht, die durch die auf dem Meßgerät angeordnete zweite Schalteinrichtung (504, 509) erzeugt werden, wodurch das Meßgerät in einem beliebigen der Vielzahl von Testparameterformaten und in einem beliebigen der Vielzahl von Darstellungsformaten arbeiten kann, und eine Multimeterschalter mit selbsttätiger Meßbereichsumschaltung (510) aufweist, die entsprechend dem Testsignal ein Meßgeräteausgangssignal erzeugen kann, das bezeichnend für einen gemessenen Parameterwert ist und dem Mikroprozessor (500, 590) zugeleitet wird, wobei der Mikroprozessor (500, 590) eine Einrichtung (520) aufweist, um die Vielzahl von Darstellungsformaten zu speichern und ein gewähltes Darstellungsformat einem Sprachsynthesizer (540, 596) zuzuleiten, wodurch der Sprachsynthesizer die Testergebnisse in einem gewählten Format akustisch ausgibt.

12. Prüfmeßgerät nach Anspruch 11, dadurch gekennzeichnet, daß eine Elektronikeinrichtung (506) des weiteren für die Speicherung einer Vielzahl von Testformaten und für die Beaufschlagung der Multimeterschaltung mit selbsttätiger Meßbereichsumschaltung (510) mit einem gewählten Testformat sorgt und daß der Mikroprozessor (500) dazu programmiert ist, den Sprachsynthesizer (540, 596) zur akustischen Ausgabe einer Testformatmitteilung als Antwort auf die Wahl eines gegebenen Testformates zu veranlassen.

13. Prüfmeßgerät nach Anspruch 11 oder 12, gekennzeichnet durch einen Hilfsmikroprozessor (594), der mit dem Mikroprozessor (500, 590) verbunden ist und eine Einrichtung (626) zum Speichern von Worten aufweist, die in einer gewünschten Sprache akustisch reproduzierbar und repräsentativ für die verschiedenen Messungen, Funktionen und Modi in Verbindung mit den Parametern sind, die durch das Meßgerät gemessen und angezeigt werden können, wobei der Hilfsmikroprozessor (594) zwischen den ersten Mikroprozessor (500, 590) und den Sprachsynthesizer (540, 596) gekoppelt ist, und in einer durch eine Vielzahl von Meßgerätedatensignalen vom Mikroprozessor (500, 590) festgelegten Weise eine Vielzahl von Befehlssignalen an den Sprachsynthesizer (540, 596) liefert, wodurch dieser nach auf die gewünschte Sprache anwendbaren Regeln hörbare Wiedergaben von aus der Vielzahl ausgewählten Meßgerätedatensignalen erzeugt.

14. Prüfmeßgerät nach Anspruch 13, dadurch gekennzeichnet, daß der Hilfsmikroprozessor (594) und der Sprachsynthesizer (540, 596) zusammen ein Sprachmodul (592) definieren, welches unabhängig vom Mikroprozessor (500, 590) auswechselbar und ersetzbar ist.

15. Prüfmeßgerät nach Anspruch 13 oder 14, dadurch gekennzeichnet, daß der Mikroprozessor (500, 590) des weiteren auf Verlangen ein Sprachwahlsignal erzeugen kann und daß der Hilfsmikroprozessor (594) eine Einrichtung aufweist, die auf ein Sprachwahlsignal vom Mikroprozessor anspricht, um die Weitergabe einer Vielzahl von Befehlssignalen an den Sprachsynthesizer (540, 596) einzuleiten.

16. Prüfmeßgerät nach Anspruch 15, gekennzeichnet durch Richteinrichtungen im Mikroprozessor (500, 590) zur Weitergabe der Vielzahl von Meßgerätdatensignalen an den Hilfsmikroprozessor (594) als Antwort auf ein Sprachwahlsignal.

17. Prüfmeßgerät nach Anspruch 16, gekennzeichnet durch eine Einrichtung im Sprachsynthesizer (540, 596), um Sprachregelsignale zur Festlegung einer Befehlssignalfolge zu speichern, die zur Erzeugung von akustischen, der gewünschten Sprache entsprechenden Wiedergaben benötigt wird.

18. Prüfmeßgerät nach einem der Ansprüche 13 bis 17, gekennzeichnet durch eine Elektronikeinrichtung zur Auswahl einer gewünschten Anzeigegenauigkeit von Parametermeßwerten und zur Erzeugung eines hierfür bezeichnenden Abrundungssignals und durch eine Elektronikeinrichtung, die auf das Abrundungssignal zur Steuerung der Auswahl der Befehlssignale anspricht, um eine hörbare Aussprache des angezeigten Parametermeßwertes zu erzeugen.

19. Prüfmeßgerät nach Anspruch 18, gekennzeichnet durch eine Einrichtung zum Abrunden angezeigter Parametermeßwerte auf eine gewünschte Stelle auf der rechten Seite des Dezimalpunktes und zur Erzeugung eines hierfür bezeichnenden Abrundungssignals.

**20.** Prüfmeßgerät nach Anspruch 19, dadurch gekennzeichnet, daß die Vielzahl von Meßdatensignalen, die an den Mikroprozessor (500, 590) weitergegeben werden, das Abrundungssignal enthalten.

**21.** Prüfmeßgerät nach Anspruch 19, gekennzeichnet durch eine Einrichtung zur Erzeugung eines ersten Temperatursignals, welches die Messung mit einem ersten Temperaturmeßfühler repräsentiert, durch eine Einrichtung zur Erzeugung eines zweiten Temperatursignals, welches die Messung mit einem zweiten Temperaturmeßfühler repräsentiert, und durch eine Einrichtung zur Erzeugung eines Signals, welches die Differenz zwischen dem ersten und dem zweiten Temperatursignal repräsentiert.

**Revendications**

**1.** Dispositif de mesure (10) agencé pour contrôler une série de paramètres mesurables, comprenant des moyens indicateurs (13, 15) afin de donner à un utilisateur une indication respective de chacun desdits paramètres, une sonde (16) qui peut être positionnée et déplacée indépendamment afin de capter un paramètre et de fournir à l'appareil de mesure un signal de contrôle indicatif de ce paramètre, des moyens de commande (300, 400, 570) par lesquels l'utilisateur peut amener le dispositif de mesure (10) à donner lesdites indications respectives, et des moyens sélecteurs (502, 504, 509), sensibles à des signaux électriques que l'utilisateur amène à être engendrés sur un conducteur électrique afin de modifier le format d'un rapport produit par le dispositif de mesure (10), en passant par une série de formats différents selon une séquence prédéterminée, et afin de modifier les formats de paramètres de contrôle utilisés par le dispositif de mesure en passant par une série de formats différents selon une séquence prédéterminée, caractérisé en ce que la sonde (16) comprend un fil d'amenée allongé à conducteurs multiples (22, 28, 30, 38, 39, 46, 48) relié de façon détachable au Dispositif de mesure (10); l' un des conducteurs (38, 39) du fil d'amenée à conducteurs multiples (22, 28, 30, 38, 39, 46, 48) étant couplé à des premiers moyens de commutation (508, 509) des moyens sélecteurs et l'autre des conducteurs (46, 48) du fil d'amenée à conducteurs multiples (22, 28, 30, 38, 39, 46, 48) étant couplé à des deuxièmes moyens de commutation (502, 504) des moyens sélecteurs; la sonde (16) étant pourvue d'un premier commutateur de commande (32) couplé afin d'envoyer un signal électrique sur ledit premier conducteur (38, 39) dans le fil d'amenée (22, 28, 30, 38, 39, 46, 48) de façon à mettre en oeuvre les premiers moyens de commutation (508, 509) afin de modifier le format de rapport du dispositif de mesure (10); et la sonde (16) étant pourvue d'un deuxième commutateur de commande (40) couplé afin d'envoyer un signal électrique sur ledit autre conducteur (46, 48) dans le fil d'amenée (22, 28, 30, 38, 39, 46, 48) de façon à mettre en oeuvre les deuxièmes moyens de commutation (502, 504) afin de modifier le format des paramètres de contrôle du dispositif de mesure de contrôle (10).

**2.** Dispositif de mesure selon la revendication 1, caractérisé en ce que ladite sonde (16) inclut en outre un thermocouple (26) destiné à capter la température, les fils d'amenée (28, 30) du thermocouple étant couplés au dispositif de mesure au moyen de conducteurs additionnels dudit fil d'amenée à conducteurs multiples (22, 28, 30, 38, 39, 46, 48).

**3.** Dispositif de mesure selon la revendication 1, caractérisé en ce que lesdits moyens indicateurs (13, 15) incluent des moyens audibles de rapport (15) afin d'effectuer un rapport audible desdits paramètres.

**4.** Dispositif de mesure selon la revendication 3, caractérisé en ce que lesdits premiers moyens de commutation permettent une commande desdits moyens audibles de rapport (15).

**5.** Dispositif de mesure selon la revendication 3 ou 4, caractérisé en ce que lesdits moyens audibles de rapport (15) destinés à exécuter un rapport audible d'une information de contrôle comprennent: des moyens de synthétise de parole (540, 596), des moyens de microprocesseur (500, 590) programmés pour fonctionner avec les moyens de synthétise de parole (540, 596) et un amplificateur (542, 670) et un haut-parleur (544) pour rapporter lesdits paramètres sous forme de parole,

**6.** Dispositif de mesure selon la revendication 5, caractérisé en ce que lesdits moyens audibles de rapport (15) prévus pour rapporter de façon audible une information de contrôle comprennent en outre des moyens électroniques (520) de mémorisation de ladite série de formats de rapports.

**7.** Dispositif de mesure selon la revendication 1, caractérisé en ce qu'il peut exécuter un rapport de résultats de contrôle sous forme de parole dans l'un quelconque d'une série de formats de rapports qui peuvent être choisis et en ce qu'il comprend en outre: des moyens de microprocesseur (500, 590) pour commander le rapport de résultats de contrôle sous forme de parole; des moyens de réception d'un signal de contrôle, engendrant une sortie du dispositif de mesure indicative d'une valeur mesurée d'un paramètre, et d'envoi de ladite sortie du dispositif de mesure auxdits moyens de microprocesseur (500, 590); des moyens (520) de mémorisation d'une série de formats de rapports qui peuvent être choisis et d'envoi d'un rapport choisi auxdits moyens de microprocesseur (500, 590); et un synthétiseur de parole (540, 596); dans lequel lesdits premiers moyens de commutation amènent de façon sélective un format particulier de rapport à être envoyé audit microprocesseur (500, 590); et lesdits moyens de microprocesseur (500, 590) sont programmés pour recevoir ladite sortie du dispositif de mesure et amener un synthétiseur de parole (540, 596) à rapporter de façon audible des résultats de contrôle dans un format choisi.

8. Dispositif de mesure selon la revendication 7 caractérisé en ce que la liaison détachable (100, 200) de ladite sonde (16) audit dispositif de mesure de contrôle inclut une liaison auxdits moyens de réception de signaux de contrôle, et la sonde (16) est configurée afin d'être maintenue et positionnée à la main et le premier et le deuxième commutateurs de commande (32, 40) peuvent être mis en oeuvre à la main tandis que la sonde (16) est tenue en contact avec un point de contrôle souhaité.

9. Dispositif de mesure selon la revendication 8 caractérisé en ce que la sonde (16) inclut en outre un moyen (26) capteur de température couplé par l'intermédiaire du fil d'amenée à conducteurs multiples (22, 28, 30, 38, 39, 46, 48) à une moitié (100) d'un connecteur séparable en commun avec des conducteurs destinés à d'autres composants de la sonde (16), et le dispositif de mesure inclut sur un boîtier (12) une moitié d'accouplement (200) d'un connecteur séparable qui est configuré pour recevoir la première moitié (100) dudit conducteur en couplant ainsi de façon détachable audit dispositif de mesure ledit fil d'emenée à conducteurs multiples (22, 28, 30, 38, 39, 46, 48).

10. Dispositif de mesure selon l'une quelconque des revendications précédentes, caractérisé en ce que la sonde (16) comprend une sonde de contact (20) configurée pour être maintenue et positionnée à la main à l'emplacement d'un point de contrôle souhaité et les moyens commutateurs de commande (32, 40) peuvent être mis en oeuvre à la main tandis que la sonde (16) est maintenue en contact avec un point de contrôle souhaité.

11. Dispositif de mesure selon la revendication 1, caractérisé en ce que lesdits moyens de sélecteur comprennent des moyens de microprocesseur (500, 590), qui peuvent être mis en oeuvre en réponse auxdits signaux électriques à distance (502, 508) qui sont amenés à être engendrés par l'opérateur ainsi qu'à des signaux électriques fournis par lesdits deuxièmes moyens de commutation (504, 509) situés sur le dispositif de mesure afin d'amener le dispositif de mesure à fonctionner dans l'un quelconque des formats d'une série de formats de paramètres de contrôle et dans l'un quelconque des formats de ladite série de formats de rapports; un circuit (510) à dispositif de mesures multiples à détermination automatique de plage, susceptible d'engendrer une sortie de dispositif de mesure en réponse au signal de contrôle et indicative donc d'une valeur mesurée d'un paramètre et d'envoyer la sortie du dispositif de mesure aux moyens de microprocesseur (500, 590); les moyens de microprocesseur (500, 590) incluant un moyen (520) qui mémorise ladite série de formats de rapports et envoie un format choisi à des moyens de synthétiseur de parole (540, 596) pour amener les moyens de synthétiseur de parole à rapporter de façon audible des résultats de contrôle dans un format choisi.

12. Dispositif de mesure selon la revendication 11, caractérisé en ce qu'il est prévu en outre des moyens électroniques (506) pour mémoriser une série de formats de contrôle et pour envoyer un format choisi parmi les formats de contrôle au circuit (510) à dispositif de mesures multiples à détermination automatique de plage; et le moyen de microprocesseur (500) est programmé de façon à amener le synthétiseur de parole (540, 596 à rapporter de façon audible un message de format de contrôle en réponse à un choix d'un format de contrôle donné.

13. Dispositif de mesure selon l'une des revendications 11 et 12, caractérisé en ce qu' un moyen de microprocesseur asservi (594) est relié en fonctionnement aux moyens de microprocesseur (500, 590) et incluent un moyen (626) de mémorisation de mots qui doivent être reproduits de façon audible dans un langage souhaité et sont représentatifs des diverses mesures, fonctions et modes liés à des paramètres qui peuvent être mesurés et affichés par le dispositif de mesure; le moyen de microprocesseur asservi (594) étant effectivement couplé entre les premiers moyens de microprocesseur (500, 590) et le synthétiseur de parole (540, 596) pour envoyer, selon la détermination de ladite série de signaux de données du dispositif de mesure provenant des moyens de microproccsseur (500, 590), une série de signaux d'ordres au synthétiseur de parole (540, 596) pour amener ce dernier à engendrer des reproductions audibles de signaux choisis parmi ladite série de signaux de données du dispositif de mesure conformément à des règles applicables audit langage souhaité.

14. Dispositif de mesure selon la revendication 13, caractérisé en ce que ledit moyen de microprocesseur asservi (594) et le synthétiseur de parole (540, 596) définissent ensemble un module de parole (592) qui est détachable et remplaçable indépendamment des moyens de microprocesseur (500, 590).

15. Dispositif de mesure selon la revendication 13 ou 14, caractérisé en ce que les moyens de microprocesseur (500, 590) peuvent en outre engendrer à la demande des signaux de demande de parole; et le moyen de microprocesseur asservi (594) inclut un moyen sensible à un signal de demande de parole provenant des moyens de microprocesseur pour lancer l'envoi de ladite série de signaux d'ordres au synthétiseur de parole (540, 596).

16. Dispositif de mesure selon la revendication 15, caractérisé par des moyens d'orientation situés dans les moyens de microprocesseur (500, 590) pour envoyer effectivement au moyen de microprocesseur asservi (594), en réponse à un signal de demande de parole, ladite série de signaux de données de dispositif de mesure.

17. Dispositif de mesure selon la revendication 16, caractérisé par des moyens situés dans le synthétiseur de parole (540, 596) pour mémoriser des signaux de règles de parole afin de déterminer une séquence de signaux d'ordres nécessaires pour produire lesdites reproductions audibles compatibles avec le langage souhaité.

18. Dispositif de mesure selon l'une quelconque des revendications 13 à 17, caractérisé par des moyens électroniques prévus pour choisir une résolution souhaitée d'affichage de mesures de paramètres et pour produire un signal d'arrondissement qui en est indicatif; et des moyens électroniques sensibles au signal d'arrondissement pour commander la sélection desdits signaux d'ordres afin d'établir une prononciation audible de la mesure affichée de paramètres.

19. Dispositif de mesure selon la revendication 18, caractérisé par des moyens d'arrondissement de mesures de paramètres affichés à un emplacement souhaité sur le côté droit de la virgule décimale et de génération dudit signal d'arrondissement qui en est indicatif.

20. Dispositif de mesure selon la revendication 19, caractérisé en ce que la série de signaux de données du dispositif de mesure qui sont envoyés aux moyens de microprocesseur (500, 590) inclut ledit signal d'arrondissement.

21. Dispositif de mesure selon la revendication 19, caractérisé par des moyens générateurs d'un premier signal de température représentatif d'une mesure à l'aide d'une première sonde de température; des moyens générateurs d'un deuxième signal de température représentatif d'une mesure à l'aide d'une deuxième sonde de température; et des moyens générateurs d'un signal représentatif de la différence entre le premier et le deuxième signaux de température.

FIG. 1

FIG. 2

FIG. 3

PROBE

THERMOCOUPLE

REPORT FORMAT
SELECTOR SWITCH

TEST FORMAT
SELECTOR SWITCH

*FIG. 4*

*FIG. 5*

EP 0 318 549 B1

MAY BE LOCATED ON PROBE

PANEL BASED
REPORT FORMAT *509*
SWITCH

LCD DISPLAY *530*

*508*

REMOTE REPORT
FORMAT SWITCH

*502*

REMOTE TEST
FORMAT SWITCH

*500*

MICROPROCESSOR

*542*

AMPLIFIER → SPEAKER

*544*

PANEL TEST
FORMAT SWITCH

REPORT FORMAT
STORAGE

*520*

SPEECH
SYNTHESIZER

*540*

*504*

*506*

METER BASED
TEST FORMAT
SWITCH CIRCUITRY

AUTORANGING
DIGITAL
MULTIMETER CHIP *510*

ANALOG SIGNALS IN

FIG. 6

EP 0 318 549 B1

FIG. 7

FIG. 8

FIG. 9

FIG. 10

FIG. 11

FIG. 12

FIG. 13

SPEAK DISPLAY

FIG. 14

---

METER DATA

---

CURRENT READING: (4 DIGITS)

CURRENT DISPLAY: (4 DIGITS)

ZERO FLAG: NON-ZERO (O), ZERO (1)

SIGN FLAG: POSITIVE (O), NEGATIVE (1)

NUMBER OF DISPLAYED DIGITS AFTER RADIX POINT: (0-3)

PRESENT FUNCTION: T(O), mV(1), V(2), OHMS(3),
mA(4), A(5)

RANGE OF PRESENT FUNCTION: (0-7)

NEW FUNCTION FLAG: OLD (O), NEW (1)

TEMPERATURE MODE: T1(O), T2(1), T1-T2(2)

TEMPERATURE UNIT: DEGREES C°(O), DEGREES F°(1)

WAVEFORM TYPE: DC (O), AC(1)

OVERRANGE FLAG: WITHIN RANGE (O), OVERRANGE(1)

CONTINUITY FLAG: OPEN CIRCUIT (O), SHORT CIRCUIT (1)

NUMBER OF DELAY LOOPS TO PERFORM

*FIG. 15*

---

SPEECH STORED DATA

---

"ZERO" THROUGH "TWENTY"

"THIRTY", "FORTY", ... "HUNDRED"

"THOUSAND"

"POINT", "MINUS", "NEGATIVE"

"MILLI", "MEGA", "K", "C", "F", "A.C.", "D.C."

"T", "VOLTS", "AMPS", "OHMS", "DEGREES"

"OVERRANGE", "OPEN", "SHORT", "CIRCUIT"

*FIG. 16*

FIG. 17

RADIX OF FOUR
(4,000 MAX)

SPEAK THOUSANDS DIGIT
IF NOT ZERO — 780

SPEAK HUNDREDS DIGIT
IF NOT ZERO — 782

IS TENTH DIGIT A
TEENS NUMBER ? — YES

NO — 784

SPEAK TENS DIGIT
IF NOT ZERO

SPEAK TENS
NUMBER

SPEAK ONES DIGIT — 786

788

RETURN

*FIG. 18*

RADIX OF THREE
(400.0 MAX)

SPEAK HUNDREDS
TENS, ONES, IF ANY

ARE THERE NUMBERS
AFTER RADIX POINT ? — 794

NO

YES — 796

SPEAK DECIMAL
"POINT"

798

SPEAK FIRST DIGIT
AFTER DECIMAL POINT

RETURN

*FIG. 19*

RADIX OF TWO
(40.00 MAX.)

SPEAK TENS AND
ONES IF ANY

NO — ARE THERE NUMBERS
AFTER RADIX POINT ? — 794

YES

SPEAK DECIMAL
"POINT" — 796

SPEAK FIRST DIGIT
AFTER DECIMAL POINT — 798

SPEAK SECOND DIGIT
AFTER DECIMAL POINT
IF NOT ZERO — 800

RETURN

*FIG. 20*

RADIX OF ONE
(4.000 MAX.)

SPEAK ONES
IF NOT ZERO

SPEAK "POINT" IF
THERE ARE DIGITS — 794

SPEAK DIGITS AFTER
DECIMAL POINT — 802

RETURN

*FIG. 21*